# EUROPÄISCHE PATENTSCHRIFT

(11) **EP 3 741 713 B1**
(45) Veröffentlichungstag und Bekanntmachung des Hinweises auf die Patenterteilung: **02.03.2022**
(21) Anmeldenummer: 20169959.2
(22) Anmeldetag: 16.04.2020
(51) Int. Cl.: B65G 43/08, G01S 11/02, G01S 13/04, G01V 3/12

(54) **SENSOREINRICHTUNG ZUM ERKENNEN AUFEINANDERFOLGENDER OBJEKTE**
SENSOR DEVICE FOR DETECTING SUCCESSIVE OBJECTS
DISPOSITIF CAPTEUR PERMETTANT DE DÉTECTER DES OBJETS SUCCESSIFS

(30) Priorität: 20.05.2019 DE 102019113219
(43) Veröffentlichungstag der Anmeldung: 25.11.2020
(73) Patentinhaber: SICK AG, 79183 Waldkirch (DE); Deutsche Post AG, 53113 Bonn (DE)
(72) Erfinder: PRINZ, Oliver, 79183 Waldkirch (DE); IMM, Rainer, 79288 Gottenheim (DE); HARTMANN, Bernd, 53501 Grafschaft-Leimersdorf (DE)
(74) Vertreter: Manitz Finsterwald Patent- und Rechtsanwaltspartnerschaft mbB

(56) Entgegenhaltungen:
- EP-A1- 3 435 115
- DE-A1-102010 055 552
- DE-A1-102014 109 399
- DE-B3-102015 110 491
- US-A1- 2016 047 757

## Beschreibung

Die vorliegende Erfindung betrifft ein Verfahren zum Erkennen aufeinanderfolgender Objekte auf einer Förderstrecke, eine Sensoreinrichtung zum Erkennen aufeinanderfolgender Objekte auf einer Förderstrecke, sowie eine Fördereinrichtung mit einer Sensoreinrichtung zum Erkennen aufeinanderfolgender Objekte auf einer Förderstrecke.

Fördereinrichtungen werden unter anderem in Lagerhallen oder Sortierzentren für den Transport unterschiedlichster Objekte, beispielsweise einzelner Pakete, Stückgutbehälter oder ähnlichem, verwendet und können als Rollenförderer oder Gurtförderer ausgebildet sein. Oftmals entsteht auf Förderstrecke derartiger Fördereinrichtungen ein unkontrollierter Objektfluss, bei dem einzelne Objekte nebeneinander oder aufeinander liegen. Dies kann beispielsweise daher rühren, dass die geförderten Objekte an verschiedenen Stellen und unkontrolliert auf die Förderstrecke gelangen, etwa indem sie geworfen oder gekippt werden. Zudem kann es im Förderungsverlauf zu ungewollten Aussparungen oder Aufhäufungen kommen, etwa wenn sich einzelne Objekte an Engstellen verkeilen.

Für eine korrekte und zerstörungsfreie weitere Handhabe der geförderten Objekte, beispielsweise für eine korrekte Sortierung der Objekte, ist es jedoch oftmals notwendig, dass die Pakete einzeln und voneinander beanstandet gefördert werden. Die Vereinzelung aneinander- oder übereinanderliegender Objekte erfolgt üblicherweise durch sogenannte Singulatoren, die in der Förderstrecke angeordnet sind. Zur Ansteuerung der Singulatoren und zur Überwachung der durch die Singulatoren vorgenommenen Vereinzelung, werden Sensoren eingesetzt, die erkennen, ob zwischen den Objekten ausreichende Abstände bestehen oder fälschlicherweise zwei Objekte aneinander- oder übereinanderliegen.

Sensoren, mittels derer eine unzureichende Trennung oder Vereinzelung aufeinanderfolgender Objekte auf einer Förderstrecke detektiert werden kann, sind üblicherweise als optische Sensoren, etwa als Laserscanner oder Lichtschranken, oder als Ultraschallsensoren ausgebildet. Die Sensoren sind dabei üblicherweise oberhalb der Förderstrecke angeordnet und von oben auf die Förderstrecke gerichtet, was einen vergleichsweise hohen Montageaufwand nach sich zieht. Zudem können die geförderten Objekte an die zur Montage verwendeten, die Förderstrecke umgreifenden Montagerahmen anstoßen und dabei beschädigt werden. Abgesehen vom Montageaufwand haben optische Sensoren zusätzlich den Nachteil, dass sie empfindlich gegenüber Fremdlichteinwirkung, Verschmutzungen, Staub oder dergleichen sind.

Druckschrift EP 3 435 115 A1 beschreibt eine Fördereinrichtung, welche nacheinander angeordnete Förderelemente aufweist, wobei sich die Förderelemente gemeinsam entlang einer Förderrichtung bewegen und wobei die einzelnen beweglichen Förderelemente jeweils Mikrowellenresonatoren aufweisen. Druckschrift DE 10 2014 109 399 A1 offenbart ein Verfahren zum Erkennen aufeinanderfolgender Objekte nach dem Oberbegriff des Anspruchs 1 und eine Sensoreinrichtung nach dem Oberbegriff des Anspruchs 13.

Druckschrift US 2016/047757 A1 beschreibt Sicherheitsschleusen zur Personenkontrolle von beispielsweise Flughäfen und dabei verwendete Verfahren und Anordnungen zur Detektion von Objekten mittels Mikrowellenstrahlung. Druckschrift DE 10 2015 110 491 B1 beschreibt eine Vorrichtung zur Ermittlung charakteristischer Messgrößen von Objekten auf einer Transporteinrichtung. Druckschrift DE 10 2010 055 552 A1 beschreibt eine Schaltung zur Erkennung der Oberflächenbeschaffenheit von Körpern, die durch das Nahfeld einer Antenne geführt werden. Druckschrift US 6 278 270 B1 beschreibt einen Magnetfeldsensor zur Messung eines Abstandes zweier einander gegenüberliegender Rollenoberflächen.

Es ist Aufgabe der Erfindung ein Verfahren zum Erkennen aufeinanderfolgender Objekte auf einer Förderstrecke, eine Sensoreinrichtung und eine Fördereinrichtung derart anzugeben, dass die aufeinanderfolgenden Objekte zuverlässig und ohne großen Montageaufwand erfasst werden können.

Diese Aufgabe wird durch ein Verfahren, eine Sensoreinrichtung und eine Fördereinrichtung gemäß den unabhängigen Ansprüchen gelöst. Weiterbildungen sind jeweils in den abhängigen Ansprüchen angegeben.

Das erfindungsgemäße Verfahren nach Anspruch 1 zum Erkennen aufeinanderfolgender Objekte auf einer Förderstrecke in einem auf der Förderstrecke angeordneten Detektionsbereich umfasst die folgenden Schritte:
- Erzeugen eines in den Detektionsbereich ausstrahlenden elektromagnetischen Hochfrequenzfeldes mittels eines an der Förderstrecke angeordneten Hochfrequenzsensors,
- Messen eines zeitlichen Verlaufs einer dielektrischen Leitfähigkeit in dem Detektionsbereich mittels des Hochfrequenzfeldes des Hochfrequenzsensors,
- Bestimmen von Konturinformationen der aufeinanderfolgenden Objekte aus dem zeitlichen Verlauf der dielektrischen Leitfähigkeit mittels einer mit dem Hochfrequenzsensor verbundenen Auswerteeinrichtung.

Im Rahmen der Erfindung wurde erkannt, dass auf der Förderstrecke aufeinanderfolgende Objekte besonders zuverlässig und einfach erkannt und voneinander unterschieden werden können, indem der zeitliche Verlauf der dielektrischen Leitfähigkeit gemessen und aus dem gemessenen Verlauf Konturinformationen der aufeinanderfolgenden Objekte bestimmt werden. Die zeitliche Variation der dielektrischen Leitfähigkeit in dem Detektionsbereich hängt insbesondere von dem Material der den Detektionsbereich durchquerenden Objekte ab, sodass die Objekte mittels der Messung der dielektrischen Leitfähigkeit auch anhand ihrer Materialien voneinander unterschieden werden können.

Der Hochfrequenzsensor kann insbesondere unter der Förderstrecke, d. h. auf einer den geförderten Objekte gegenüberliegenden Seite der Förderstrecke (z. B. eines Transportbandes), angeordnet sein und das Hochfrequenzfeld kann von der Unterseite der Förderstrecke aus in den Detektionsbereich eingestrahlt werden. Dadurch kann eine den Hochfrequenzsensor umfassende Sensoreinrichtung besonders platzsparend aufgebaut werden, ohne dass neben oder über der Förderstrecke angeordnete Komponenten benötigt werden.

Eine Fördereinrichtung, welche die Objekte entlang der Förderstrecke bewegt, kann beispielsweise als ein Rollenförderer, etwa als eine Rollenbahn, oder als ein Gurtförderer, beispielsweise als ein planares Förderband, ausgebildet sein. Die Fördereinrichtung kann insbesondere Transportrollen umfassen, wobei die Objekte entweder direkt auf den Transportrollen aufliegen können, etwa bei einem Rollenförderer, oder aber auf einem über die Transportrollen laufenden Förderelement, etwa auf einem Fördergurt bei einem Gurtförderer.

Der Hochfrequenzsensor kann unter oder zwischen den Transportrollen der Fördereinrichtung angeordnet sein. Besonders vorteilhaft, weil platzsparend, ist es, wenn der Hochfrequenzsensor in einer Transportrolle angeordnet ist. Zwischen dem Hochfrequenzsensor und dem Detektionsbereich kann sich insbesondere eine dielektrische Schicht befinden, beispielsweise ein Teil einer aus dielektrischem Material gefertigten Transportrolle oder ein Teil eines dielektrischen Fördergurts. Eine Dicke der dielektrischen Schicht kann weniger als eine Wellenlänge, insbesondere weniger als ein Zehntel der Wellenlänge, insbesondere weniger als ein Hundertstel der Wellenlänge des von dem Hochfrequenzsensor ausgestrahlten elektromagnetischen Hochfrequenzfeldes betragen.

Der das in den Detektionsbereich ausstrahlende elektromagnetische Hochfrequenzfeld erzeugende Hochfrequenzsensor kann beispielsweise als ein Hochfrequenzresonator, eine Hochfrequenzantenne oder eine Hochfrequenzleitung ausgebildet sein. Der Hochfrequenzsensor kann dabei als eine Hohlleiterstruktur oder als eine Planarleiterstruktur ausgebildet sein. Die Hohlleiterstruktur kann insbesondere als Hohlraumresonator, als Hornantenne oder als Wellenleiter (Hohlleiter) ausgebildet sein. Die Planarleiterstruktur kann etwa als Microstrip-Leiterstruktur oder Coplanar-Waveguide-Leiterstruktur (CPW-Leiterstrutkur), etwa als Microstrip-oder CPW-Resonator, als Patch-Antenne oder als Microstrip- oder CPW-Leitung ausgebildet sein.

Eine Änderung der dielektrischen Leitfähigkeit in dem Detektionsbereich kann beispielsweise dadurch gemessen werden, dass sich eine Resonanzfrequenz des Hochfrequenzsensors und/oder eine Impedanz des Hochfrequenzsensors in Abhängigkeit von dem Material der in den Detektionsbereich eintretenden Objekte ändert.

Als ein Sensorsignal des Hochfrequenzsensors, aus dem der zeitliche Verlauf der dielektrischen Leitfähigkeit ermittelt wird, kann ein Auskoppelsignal verwendet werden, welches aus der Leiterstruktur des Hochfrequenzsensors während oder nach Einspeisung eines Einspeisesignals ausgekoppelt wird. Bei dem Auskoppelsignal kann es sich beispielsweise um ein von der Leiterstruktur des Hochfrequenzsensors reflektiertes Reflexionssignal, etwa bei einem als Hochfrequenzresonator oder als Hochfrequenzantenne ausgebildeten Hochfrequenzsensor, oder um ein von der Leiterstruktur des Hochfrequenzsensors transmittiertes Transmissionssignal, etwa bei einem als Hochfrequenzleitung ausgebildeten Hochfrequenzsensor, handeln. Der zeitliche Verlauf der dielektrischen Leitfähigkeit kann beispielsweise aus einer Amplitudeninformation und/oder einer Phaseninformation und/oder einer Frequenzinformation des Auskoppelsignals bestimmt werden.

Um den zeitlichen Verlauf der dielektrischen Leitfähigkeit zu messen, kann das Verfahren ein Erfassen des Sensorsignals des Hochfrequenzsensors und ein Bestimmen einer die dielektrische Leitfähigkeit repräsentierenden Messgröße aus dem Sensorsignal umfassen. Bei der Messgröße kann es sich um die dielektrische Leitfähigkeit selbst, oder aber um eine von der dielektrischen Leitfähigkeit abhängende abgeleitete Messgröße handeln. Eine derartige abgeleitete Messgröße kann beispielsweise eine, insbesondere frequenzabhängige, Dämpfung und/oder eine, insbesondere frequenzabhängige, Phasenverschiebung des Auskoppelsignals in Relation zum Einspeisesignal sein.

Die Messgröße kann im Rahmen einer Datenvorverarbeitung aus dem Sensorsignal des Hochfrequenzsensors berechnet werden, beispielsweise analytisch oder numerisch. Die Konturinformationen können anschließend aus der Messgröße mittels eines Objekterkennungsverfahrens bestimmt werden, beispielsweise indem der zeitliche Verlauf der Messgröße mit zuvor eingelernten Referenzgrößen abgeglichen wird. Das Objekterkennungsverfahren kann beispielsweise als ein neuronales Netz implementiert sein. Bei dem Objekterkennungsverfahren kann beispielsweise der zeitliche Verlauf der Messgröße oder der zeitliche Verlauf der dielektrischen Leitfähigkeit als Eingangsgröße verwendet und die Konturinformationen als Ausgangsgröße bereitgestellt werden.

Beim Bestimmen der Konturinformationen können zusätzlich zu der dielektrischen Leitfähigkeit zusätzliche Messsignale berücksichtigt werden. Ein derartiges zusätzliches Messsignal kann insbesondere ein parallel zu der Förderstrecke gemessenes Objektprofil der aufeinanderfolgenden Objekte umfassen. Das Objektprofil kann beispielsweise mittels einer Kamera, eines Laserscanners oder eines Distanzsensors gemessen werden. Als zusätzliches Messsignal kann aber auch ein Beschleunigungssignal eines zusätzlich zu dem Hochfrequenzsensor unter der Förderstrecke angeordneten Beschleunigungssensors berücksichtigt werden. Mittels des Beschleunigungssensors kann beispielsweise ein auf die Förderstrecke fallendes Objekt erkannt werden.

Eine Berücksichtigung zusätzlicher Messsignale ermöglicht es, besonders genaue Konturinformationen der auf der Förderstrecke aufeinanderfolgenden Objekte zu ermitteln und dadurch eine auf den Konturinformationen basierende Objekterkennung zu verbessern. Aus den zusätzlichen Messsignalen gewonnene Zusatzinformationen können beispielsweise komplementär zu den aus der Messung der dielektrischen Leitfähigkeit gewonnenen Informationen sein, wobei die komplementären Zusatzinformationen Informationen enthalten, die in den aus der dielektrischen Leitfähigkeit gewonnenen Informationen nicht direkt enthalten sind.

Die aus dem zeitlichen Verlauf der dielektrischen Leitfähigkeit bestimmten Konturinformationen können beispielsweise eine Länge, eine Breite oder eine Auflagefläche der Objekte umfassen. Die Konturinformationen können außerdem eine Position der Objekte in einer zu der Förderrichtung der Förderstrecke senkrecht orientierten Querrichtung umfassen.

Anhand der Konturinformationen können insbesondere die auf der Förderstrecke aufeinanderfolgenden Objekte voneinander unterschieden werden und es kann erkannt werden, ob die Objekte jeweils vereinzelt sind oder nicht. Werden zwei Objekte ohne Abstand, insbesondere überlappend, gefördert, so kann das Verfahren weiter ein Erzeugen eines Warnsignals umfassen. Anhand des Warnsignals kann unter anderem bestimmt werden, ob eine vorausgehende Vereinzelung erfolgreich war, und nicht vereinzelte Objekte können zur nachträglichen Vereinzelung auf Grundlage des Warnsignals aus der Förderstrecke ausgeschleust werden. Wird das Verfahren von einer vor einem Singulator angeordneten Sensoreinrichtung ausgeführt, so können die Konturinformationen dazu genutzt werden, Fördereinrichtungen des Singulators anhand der gemessenen Konturinformationen der Objekte, insbesondere anhand der gemessenen Positionen der Objekte auf der Förderstrecke, derart anzusteuern, dass eine Vereinzelung erreicht wird.

Eine Weiterbildung des Verfahrens umfasst ein Bestimmen eines Objektabstandes zweier aufeinanderfolgender Objekte als aus dem zeitlichen Verlauf der dielektrischen Leitfähigkeit bestimmte Konturinformation. Der Objektabstand aufeinanderfolgender Objekte kann insbesondere aus dem zeitlichen Abstand zwischen einer Änderung der dielektrischen Leitfähigkeit, die durch den Austritt eines vorauslaufenden Objekts aus dem Detektionsbereich verursacht wird, und einer Änderung der dielektrischen Leitfähigkeit, die durch den Eintritt eines nachfolgenden Objekts in den Detektionsbereich verursacht wird, ermittelt werden.

Eine Weiterbildung des Verfahrens umfasst ein Bestimmen eines Überlappens mehrerer aufeinanderfolgender Objekte als aus dem zeitlichen Verlauf der dielektrischen Leitfähigkeit bestimmte Konturinformation.

Eine Weiterbildung des Verfahrens umfasst ein Bestimmen von Auflagewinkeln der den Detektionsbereich durchquerenden Objekte als aus dem zeitlichen Verlauf der dielektrischen Leitfähigkeit bestimmte Konturinformation.

Ein Überlappen aufeinanderfolgender Objekte bzw. ein Auflagewinkel der den Detektionsbereich durchquerenden Objekte kann insbesondere anhand einer stetig zunehmenden oder anhand einer stetig abnehmenden dielektrischen Leitfähigkeit in dem Detektionsbereich erkannt werden, wobei die Abnahme bzw. die Zunahme der dielektrischen Leitfähigkeit durch eine Abnahme bzw. eine Zunahme desjenigen Teilbereichs des Detektionsbereichs, der durch ein schräg auf der Förderstrecke aufliegendes Objekt eingenommen wird, verursacht wird. Insbesondere kann durch eine Abnahme bzw. eine Zunahme der dielektrischen Leitfähigkeit ein nicht flächig auf der Förderstrecke aufliegendes Objekt bzw. ein lediglich mit einer Kante oder Ecke auf der Förderstrecke aufliegendes Objekt erkannt werden.

Der Detektionsbereich kann sich innerhalb des Nahfelds bzw. des evaneszenten Feldes der Leiterstruktur des Hochfrequenzsensors befinden, insbesondere kann der Detektionsbereich vollständig innerhalb des Nahfelds bzw. des evaneszenten Feldes der Leiterstruktur des Hochfrequenzsensors angeordnet sein. Ist der Detektionsbereich vollständig in einem Nahfeldbereich des Hochfrequenzfeldes des Hochfrequenzsensors angeordnet, so kann eine Entfernung des Detektionsbereichs von dem Hochfrequenzsensor vorzugsweise weniger als eine Wellenlänge des Hochfrequenzfeldes, etwa weniger als ein Drittel der Wellenlänge des Hochfrequenzfeldes, betragen. Wenn der Detektionsbereich im Nachfeldbereich des Hochfrequenzfeldes angeordnet ist, werden die in dem Detektionsbereich befindlichen Objekte mittels des evaneszenten Feldes des Hochfrequenzsensors detektiert. Dies ermöglicht eine besonders genaue und zuverlässige Messung der dielektrischen Leitfähigkeit, insbesondere im Vergleich zu einer Detektion im Fernfeld des Hochfrequenzsensors.

Alternativ kann der Detektionsbereich auch im Fernfeld des Hochfrequenzsensors angeordnet sein und die dielektrische Leitfähigkeit kann über einen von den Objekten reflektierten Anteil des durch den Hochfrequenzsensor ausgestrahlten Hochfrequenzsignals ermittelt werden. Eine Anordnung des Detektionsbereichs im Fernfeld des Hochfrequenzsensors erlaubt es, den Hochfrequenzsensor in einem größeren Abstand von der Förderstrecke anzuordnen, als es bei einer Anordnung des Detektionsbereichs im Nahfeld der Fall ist. Dadurch kann der Hochfrequenzsensor besonders flexibel positioniert werden.

Bei einer Weiterbildung des Verfahrens ist der Hochfrequenzsensor als ein Hochfrequenzresonator ausgebildet und der zeitliche Verlauf der dielektrischen Leitfähigkeit wird aus einer zeitlichen Änderung einer Resonanzfrequenz des Hochfrequenzresonators ermittelt. Die Resonanzfrequenz kann beispielsweise aus einer Amplitudeninformation und/oder einer Phaseninformation des aus dem Hochfrequenzresonator ausgekoppelten Auskoppelsignals bestimmt werden. Bei dem Auskoppelsignal kann es sich insbesondere um das von dem Hochfrequenzresonator reflektierte Reflexionssignal handeln.

Bei einer Weiterbildung des Verfahrens ist der Hochfrequenzsensor als eine in den Detektionsbereich ausstrahlende Antenne ausgebildet und der zeitliche Verlauf der dielektrischen Leitfähigkeit wird aus einer zeitlichen Änderung eines von der Antenne reflektierten elektrischen Reflexionssignals ermittelt. Wie bei dem Hochfrequenzresonator kann das von der Antenne reflektierte Reflexionssignal insbesondere aus einer Amplitudeninformation und/oder einer Phaseninformation eines aus der Hochfrequenzantenne ausgekoppelten Auskoppelsignals bestimmt werden.

Bei einer Weiterbildung des Verfahrens wird die dielektrische Leitfähigkeit aus einem reflektierten Anteil eines in den Hochfrequenzsensor eingespeisten Hochfrequenzsignals ermittelt. Der reflektierte Anteil kann beispielsweise als das Auskoppelsignal gemessen werden und die dielektrische Leitfähigkeit kann beispielsweise aus einer Amplituden- und/oder Phaseninformation des Auskoppelsignals gewonnen werden.

Bei einer Weiterbildung des Verfahrens ist der Hochfrequenzsensor ein Mikrowellensensor und das Hochfrequenzfeld ein Mikrowellenfeld. Das Hochfrequenzfeld kann insbesondere eine Frequenz im Bereich von 500 MHz bis 50 GHz, insbesondere von 700 MHz bis 10 GHz, etwa von 1 GHz bis 6 GHz aufweisen.

Bei einer Weiterbildung des Verfahrens ist der Hochfrequenzsensor in einer an der Förderstrecke angeordneten Transportrolle angeordnet. In der Transportrolle kann der Hochfrequenzsensor besonders platzsparend unter der Förderstrecke angeordnet werden. Außerdem ist der Hochfrequenzsensor in der Transportrolle vor mechanischen Einflüssen geschützt.

Die Transportrolle kann insbesondere aus einem dielektrischen Material und als ein Hohlzylinder ausgebildet sein. Eine radiale Dicke der Transportrolle kann weniger als 10 mm, insbesondere weniger als 5 mm, insbesondere weniger als 3 mm betragen. Die Transportrolle kann beispielsweise einen Durchmesser zwischen 20mm und 80mm, insbesondere beispielsweise von 50mm aufweisen.

Bei einer Weiterbildung des Verfahrens ist der Hochfrequenzsensor auf einer Trägerplatte ausgebildet, welche auf der Drehachse der Transportrolle angeordnet ist. Die Trägerplatte kann insbesondere als eine Leiterplatte und der Hochfrequenzsensor als eine Planarleiterstruktur ausgebildet sein. Dadurch kann der Hochfrequenzsensor besonders einfach und kostengünstig hergestellt werden.

Erfindungsgemäß umfasst der Hochfrequenzsensor mehrere Einzelsensoren, wobei die Einzelsensoren nebeneinander entlang einer zu der Förderrichtung der Förderstrecke senkrecht ausgerichteten Querrichtung der Förderstrecke angeordnet sind. Der Detektionsbereich umfasst demnach mehrere in der Querrichtung nebeneinander angeordnete Einzeldetektionsbereiche, die jeweils einem der Einzelsensoren zugeordnet sind. Die Einzelsensoren können ein Array aus Hochfrequenzsensoren, beispielsweise ein Array aus Hochfrequenzresonatoren bilden. Mittels der Einzelsensoren kann in Querrichtung eine laterale Objektbreite der Objekte und/oder eine laterale Position der Objekte besonders genau bestimmt werden. Insbesondere kann besonders einfach erkannt werden, ob eine Vereinzelung in Querrichtung notwendig ist.

Eine Weiterbildung des Verfahrens umfasst ein Bestimmen von entlang der Querrichtung orientierten Breiten der Konturen der aufeinanderfolgenden Objekte aus Einzelsignalen der Einzelsensoren. Die Breiten der Konturen der aufeinanderfolgenden Objekte können als Konturinformationen bestimmt werden. Zur Bestimmung der Breiten werden die Einzelsignale als Einzelsignalkomponenten des Sensorsignals weiterverarbeitet.

Bei einer Weiterbildung des Verfahrens werden die Einzelsensoren zeitlich versetzt angeregt und ausgelesen. Dadurch kann eine Wechselwirkung zwischen den nebeneinander angeordneten Einzelsensoren bzw. ein Übersprechen eines eingespeisten Hochfrequenzsignals zwischen den Einzelsensoren vermieden werden. Alternativ kann auch jeweils nur einer der Einzelsensoren angeregt werden, während alle Einzelsensoren ausgelesen werden, so dass eine elektromagnetische Kopplung der Einzelsensoren gemessen und zur Bestimmung der dielektrischen Leitfähigkeit des Detektionsbereichs herangezogen werden kann. Insbesondere kann eine zeitliche Änderung der elektromagnetischen Kopplung der Einzelsensoren beim Messen des zeitlichen Verlaufs der dielektrischen Leitfähigkeit berücksichtigt werden.

Bei einer Weiterbildung des Verfahrens werden außerdem eine Fördergeschwindigkeit der Förderstrecke und Längen der Konturen der Objekte aus der Fördergeschwindigkeit und dem zeitlichen Verlauf der dielektrischen Leitfähigkeit bestimmt.

Mittels der Fördergeschwindigkeit kann eine absolute Länge der Konturen der Objekte ermittelt werden. Dies erlaubt es, auch bei variierender Fördergeschwindigkeit exakte Konturinformationen der aufeinanderfolgenden Objekte zu bestimmen.

Die Fördergeschwindigkeit kann beim Bestimmen der Konturinformationen als Eingangsgröße verwendet werden.

Bei einer Weiterbildung dieses Verfahrens wird die Fördergeschwindigkeit der Objekte entlang der Förderstrecke mittels eines Drehgebers zur Bestimmung einer Rotationsgeschwindigkeit einer an der Förderstrecke angeordneten Transportrolle ermittelt. Ein Drehgeber erlaubt eine besonders einfache und kostengünstige Bestimmung der Fördergeschwindigkeit der Förderstrecke. Insbesondere kann der Drehgeber zusammen mit dem Hochfrequenzsensor in der Transportrolle integriert angeordnet sein. Zusätzlich kann auch eine mit dem Hochfrequenzsensor und dem Drehgeber verbundene Auswerteeinrichtung zur Erzeugung der Konturinformationen in der Transportrolle angeordnet sein, beispielsweise auf der Trägerplatte des Hochfrequenzsensors. Insgesamt können also der Drehgeber und der Hochfrequenzsensor besonders platzsparend zusammen angeordnet werden.

Eine Weiterbildung des Verfahrens umfasst ein Ermitteln des Abstands zwischen dem Objekt und der Förderstrecke mittels eines unter der Förderstrecke angeordneten Distanzsensors, insbesondere mittels eines unter der Förderstrecke angeordneten optischen Tasters. Mittels des Distanzsensors können insbesondere Objekte erkannt werden, die nicht flächig auf der Förderstrecke aufliegen, beispielsweise weil sie teilweise auf einem weiteren Objekt liegen. Ein durch den Distanzsensor erzeugtes Distanzsensorsignal kann bei dem Bestimmen der Konturinformationen als Eingangsgröße verwendet werden. Analog zu dem mehrere Einzelsensoren umfassenden Hochfrequenzsensor kann auch der Distanzsensor mehrere, entlang der Querrichtung angeordnete Einzeldistanzsensoren umfassen.

Die erfindungsgemäße Sensoreinrichtung nach Anspruch 13 zum Erkennen aufeinanderfolgender Objekte auf einer Förderstrecke umfasst einen an der Förderstrecke angeordneten Hochfrequenzsensor und eine mit dem Hochfrequenzsensor verbundene Auswerteeinrichtung.

Die Sensoreinrichtung weist einen auf der Förderstrecke angeordneten Detektionsbereich auf und der Hochfrequenzsensor ist dazu ausgebildet, ein in den Detektionsbereich ausstrahlendes elektromagnetisches Hochfrequenzfeld zu erzeugen. Die Auswerteeinrichtung ist dazu eingerichtet, einen zeitlichen Verlauf einer dielektrischen Leitfähigkeit in dem Detektionsbereich mittels des Hochfrequenzfeldes des Hochfrequenzsensors zu messen. Außerdem ist die Auswerteeinrichtung dazu eingerichtet, Konturinformationen der aufeinanderfolgenden Objekte aus dem zeitlichen Verlauf der dielektrischen Leitfähigkeit zu bestimmen. Erfindungsgemäß umfasst der Hochfrequenzsensor mehrere Einzelsensoren, wobei die Einzelsensoren nebeneinander entlang einer zu der Förderrichtung der Förderstrecke senkrecht ausgerichteten Querrichtung der Förderstrecke angeordnet sind.

Die Sensoreinrichtung ist dazu ausgebildet, das erfindungsgemäße Verfahren zum Erkennen aufeinanderfolgender Objekte auf der Förderstrecke auszuführen. Insofern beziehen sich alle Weiterbildungen und Vorteile, die im Zusammenhang mit dem erfindungsgemäßen Verfahren erläutert werden, auch auf die Sensoreinrichtung.

Es wird außerdem eine Fördereinrichtung nach Anspruch 14 mit einer Förderstrecke und einer an der

Förderstrecke angeordneten Sensoreinrichtung zum Erkennen aufeinanderfolgender Objekte auf der Förderstrecke angegeben. Bei der Sensoreinrichtung handelt es sich um eine erfindungsgemäße Sensorvorrichtung.

Die Erfindung wird nachfolgend anhand von Figuren erläutert. Dabei zeigen in jeweils schematischer Darstellung:
- Fig. 1: eine erste Ausführungsform einer Fördereinrichtung mit einem Hochfrequenzsensor und drei aufeinanderfolgenden Objekten;
- Fig. 2: einen zeitlichen Verlauf von Messgrößensignalen des Hochfrequenzsensors;
- Fig. 3: eine Auswerteeinrichtung mit einem Vorverarbeitungsmodul und einem Konturerkennungsmodul;
- Fig. 4: die erste Ausführungsform der Fördereinrichtung mit zwei aufeinanderfolgenden Objekten;
- Fig. 5: eine zweite Ausführungsform der Fördereinrichtung mit einem in einer Transportrolle angeordneten Hochfrequenzsensor;
- Fig. 6: die Transportrolle mit dem darin angeordneten Hochfrequenzsensor;
- Fig. 7: eine Aufsicht auf die zweite Ausführungsform der Fördereinrichtung.

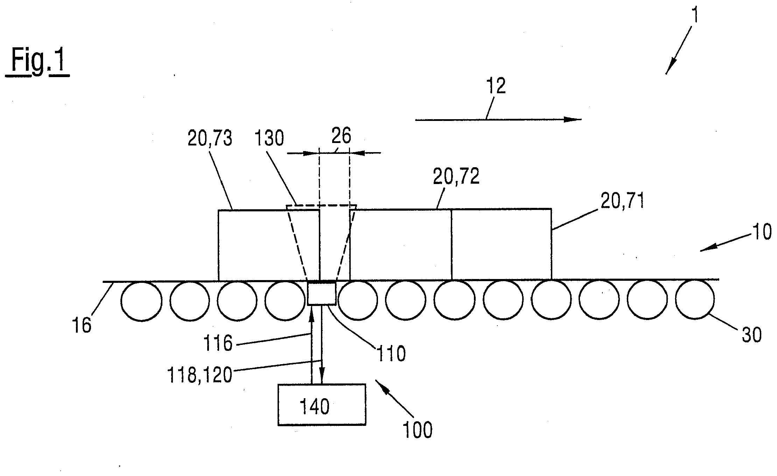

Fig. 1 zeigt eine Fördereinrichtung 1 mit einer Sensoreinrichtung 100, welche einen Hochfrequenzsensor 110 und eine Auswerteeinrichtung 140 umfasst. Die Fördereinrichtung 1 umfasst eine Förderstrecke 10, entlang derer Objekte 20 in einer Förderrichtung 12 gefördert werden. Entlang der Förderstrecke 10 verläuft ein Förderband 16, welches auf unterhalb des Förderbands 16 angeordneten Transportrollen 30 aufliegt.

Der Hochfrequenzsensor 110 der Sensoreinrichtung 100 ist zwischen den Transportrollen 30 unterhalb des Förderbands 16 und unterhalb der Förderstrecke 10 angeordnet. Ein nur schematisch angedeuteter Detektionsbereich 130 des Hochfrequenzsensors 110 reicht durch das Förderband 16 auf die Förderstrecke 10. Der Hochfrequenzsensor 110 wird von der Auswerteeinrichtung 140 mittels eines Einspeisesignals 116, welches durch ein Mikrowellensignal gebildet wird, angeregt und erzeugt als ein Sensorsignal 120 ein Auskoppelsignal 118, welches an die Auswerteeinrichtung 140 übertragen wird. Der Hochfrequenzsensor 110 ist als ein Mikrowellenresonator ausgebildet und das Auskoppelsignal 118 wird durch einen von dem Mikrowellensenator reflektierten Anteil des Einspeisesignals 116 gebildet.

Die Auswerteeinrichtung 140 ist dazu ausgebildet, mittels des Hochfrequenzsensors 110 den zeitlichen Verlauf einer dielektrischen Leitfähigkeit in dem Detektionsbereich 130 zu messen und aus dem zeitlichen Verlauf der dielektrischen Leitfähigkeit Konturinformationen der auf der Förderstrecke 10 aufeinanderfolgenden Objekte 20 zu bestimmen. In der Darstellung der Fig. 1 folgt auf ein erstes Objekt 71 ein zweites Objekt 72 und anschließend ein drittes Objekt 73. Das erste Objekt 71 und das zweite Objekt 72 liegen unmittelbar hintereinander, so dass der Abstand zwischen dem ersten Objekt 71 und dem zweiten Objekt 72 null beträgt. Das zweite Objekt 72 und das dritte Objekt 73 weisen dagegen einen von null verschiedenen Objektabstand 26 voneinander auf. Die Auswerteeinrichtung 140 ist unter anderem dazu ausgebildet, als eine Konturinformation den Objektabstand 26 zwischen dem zweiten Objekt 72 und dem dritten Objekt 73, sowie den null betragenden Objektabstand zwischen dem ersten Objekt 71 und dem zweiten Objekt 72 zu bestimmen.

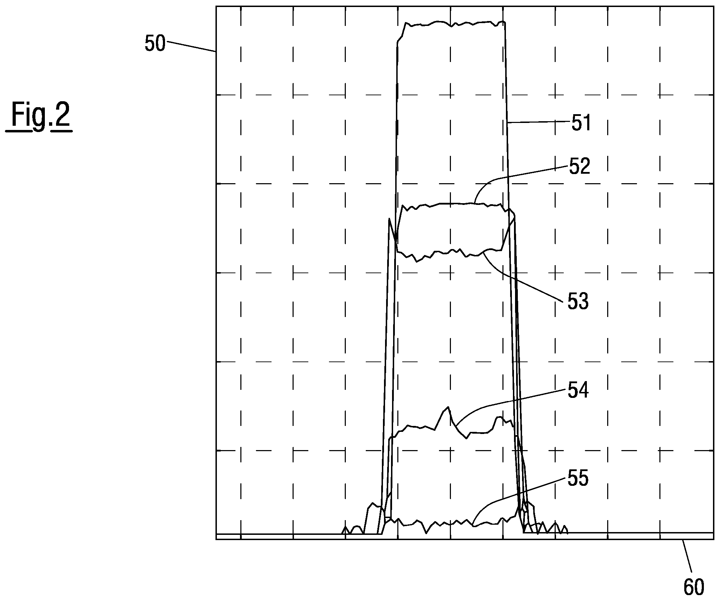

Zur Bestimmung der Konturinformationen der auf der Förderstrecke 10 aufeinanderfolgenden Objekte 20 ist die Auswerteeinrichtung 140 dazu ausgebildet, die dielektrische Leitfähigkeit als eine Messgröße aus dem Sensorsignal 120 abzuleiten. In Fig. 2 ist der Verlauf der als Messgröße abgeleiteten dielektrischen Leitfähigkeit 50 in Abhängigkeit von der Zeit 60 für Objekte 20 aus verschiedenen Materialien dargestellt. Die in Fig. 2 dargestellten Messgrößenverläufe wurden bei einer Frequenz des Hochfrequenzfeldes von 5,8 GHz gemessen. Dargestellt sind ein erster Messgrößenverlauf 51, ein zweiter Messgrößenverlauf 52, ein dritter Messgrößenverlauf 53, ein vierter Messgrößenverlauf 54 und ein fünfter Messgrößenverlauf 55, wobei die dielektrische Leitfähigkeit 50 der den Detektionsbereich 130 durchquerenden Objekte 20 bei der Frequenz des Hochfrequenzsignals von dem ersten Messgrößenverlauf 51 bis zu dem fünften Messgrößenverlauf 55 kontinuierlich abnimmt.

Der erste Messgrößenverlauf 51 wurde gemessen, während eine Transportkiste aus einem Material zur Vermeidung elektrostatischer Entladungen (ESD-Schutzmaterial) den Detektionsbereich 130 durchquerte. Der zweite Messgrößenverlauf 52, der dritte Messgrößenverlauf 53 und der vierte Messgrößenverlauf 54 wurden gemessen, während ein Objekt 20 aus Glas, Blech bzw. Holz den Detektionsbereich 130 durchquerte. Der fünfte Messgrößenverlauf 55 wurde schließlich gemessen, während eine Transportkiste aus einem Plastikmaterial den Detektionsbereich 130 durchquerte. Die zur Erzeugung der einzelnen Messgrößenverläufe 51, 52, 53, 54, 55 verwendeten Objekte 20 weisen jeweils eine identische Auflagefläche auf der Förderstrecke 10 auf.

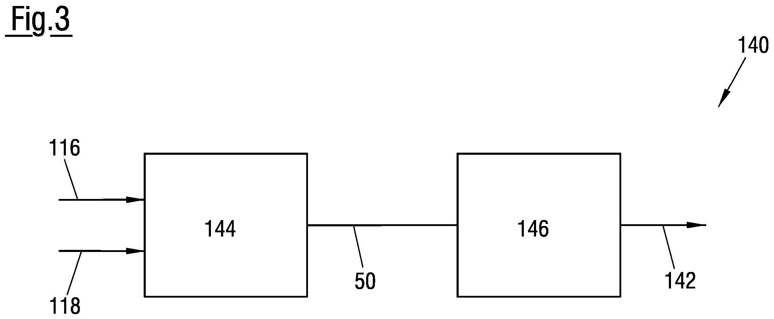

Fig. 3 zeigt ein Vorverarbeitungsmodul 144 und ein mit dem Vorverarbeitungsmodul 144 verbundenes Konturerkennungsmodul 146 der Auswerteeinrichtung 140. Das Vorverarbeitungsmodul 144 empfängt das Einspeisesignal 116 und das von dem Hochfrequenzsensor 110 übertragene Auskoppelsignal 118. Das Vorverarbeitungsmodul 144 ist dazu ausgebildet, im Rahmen einer Datenvorverarbeitung anhand eines analytischen Modells aus dem Auskoppelsignal 118 und dem Einspeisesignal 116 den zeitlichen Verlauf der dielektrischen Leitfähigkeit 50 als die an das Kontoerkennungsmodul 146 übermittelte Messgröße zu berechnen. Das Konturerkennungsmodul 146 ist dazu ausgebildet, aus dem übermittelten zeitlichen Verlauf der dielektrischen Leitfähigkeit 50 mittels eines Objekterkennungsverfahrens die Konturinformationen 142 der den Detektionsbereich 130 durchquerenden Objekte 20 zu bestimmen.

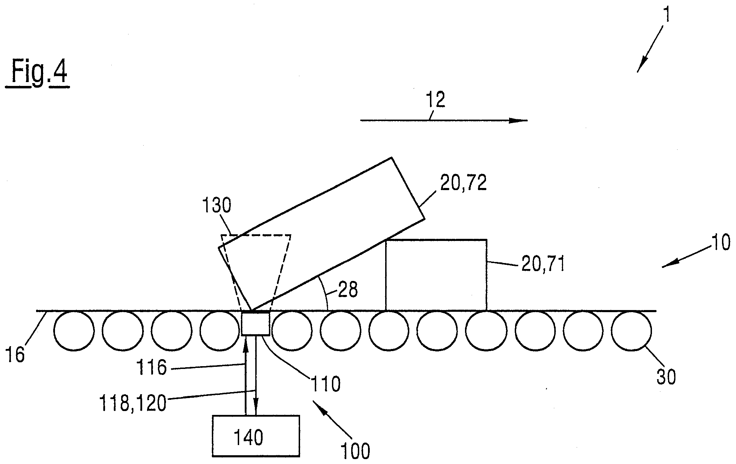

Fig. 4 zeigt die Fördereinrichtung 1 in der ersten Ausführungsform, wobei der Detektionsbereich 130 von zwei Objekten 20 durchquert wird. Wie dargestellt, liegt dabei das zweite Objekt 72 teilweise auf dem vorausgehenden ersten Objekt 71 auf. Dadurch liegt das zweite Objekt 72 nicht flächig auf der Förderstrecke 10 auf, sondern lediglich mit einer hinteren Kante. Im Rahmen der Bestimmung der Konturinformationen 142 bestimmt die Auswerteeinrichtung 140 insbesondere ein Überlappen des ersten Objekts 71 und des zweiten Objekts 72, sowie einen Auflagewinkel 28 zwischen dem zweiten Objekt 72 und der Förderstrecke 10. Das Überlappen des ersten und zweiten Objekts 71, 72 bzw. der Auflagewinkel 28 kann aus dem zeitlichen Verlauf der dielektrischen Leitfähigkeit 50 beispielsweise daraus bestimmt werden, dass die dielektrische Leitfähigkeit 50 nach Durchgang des ersten Objekts 71 durch den Detektionsbereich 130 ausgehend von einem konstanten Wert sprunghaft abfällt und anschließend bei zunehmender Ausfüllung des Detektionsbereich 130 durch das schräg liegende zweite Objekt 72 wieder kontinuierlich ansteigt.

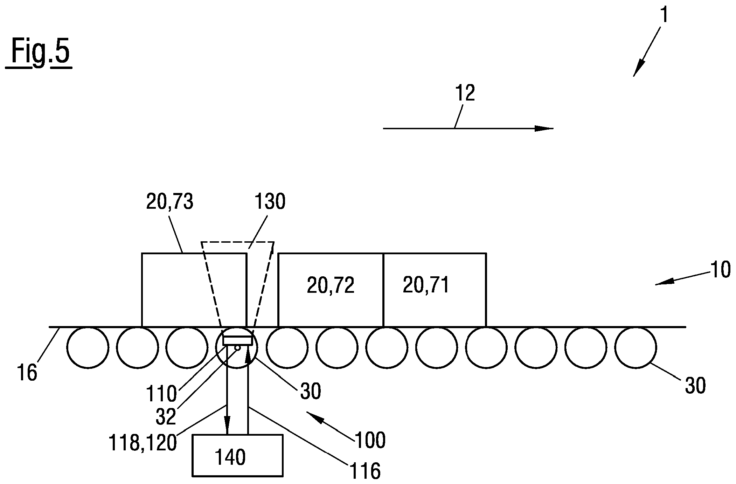

Fig. 5 zeigt eine zweite Ausführungsform einer Fördereinrichtung 1 mit einer einen Hochfrequenzsensor 110 aufweisenden Sensoreinrichtung 100. Bei der zweiten Ausführungsform der Fördereinrichtung 1 ist der Hochfrequenzsensor 110 in einer der Transportrollen 30 der Fördereinrichtung 1 angeordnet. Insbesondere ist der Hochfrequenzsensor 110 auf der Drehachse 32 der Transportrolle 30 angeordnet. Bei einem hier nicht gezeigten Ausführungsbeispiel kann auch die Auswerteeieinrichtung 140 in der Transportrolle 30 angeordnet sein.

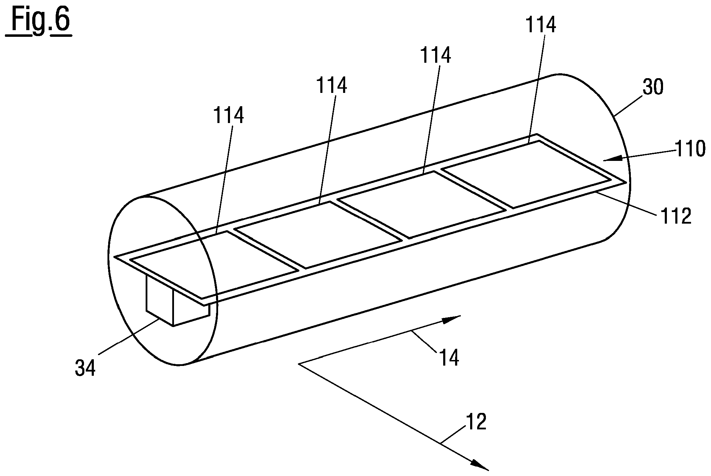

Wie in Fig. 6 dargestellt ist, weist der in der Transportrolle 30 angeordnete Hochfrequenzsensor 110 eine auf der Drehachse 32 angeordnete Trägerplatte 112, sowie mehrere, in einer Querrichtung 14 nebeneinander auf der Trägerplatte 112 angeordnete Einzelsensoren 114 auf. Die Sensoreinrichtung 100 weist außerdem einen Drehgeber 34 auf, welcher ebenfalls an der Drehachse 32 der Transportrolle 30 angeordnet ist und zumindest teilweise auf der Trägerplatte 112 ausgebildet ist. Beispielsweise kann eine Auswerteelektronik des Drehgebers 34 auf der Trägerplatte 112 ausgebildet sein. Die Einzelsensoren 114 sind jeweils als Hochfrequenzresonatoren ausgebildet und einzeln mit der Auswerteeinrichtung 140 verbunden, um die Einzelsensoren 114 zeitlich versetzt anzuregen und auszulesen.

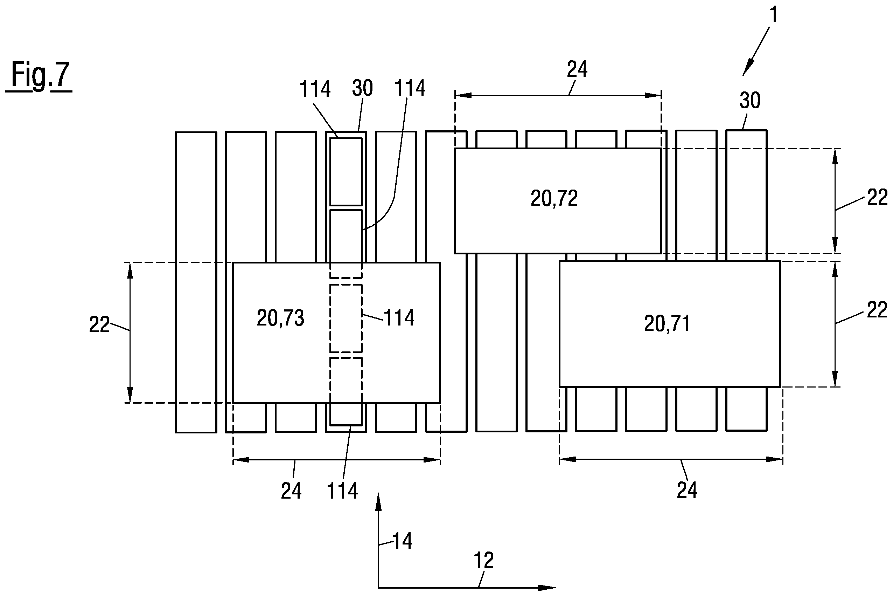

Fig. 7 zeigt eine Aufsicht auf die Fördereinrichtung 1 in der zweiten Ausführungsform mit einem ersten Objekt 71, einem zweiten Objekt 72 und einem dritten Objekt 73, welche jeweils nacheinander auf der Förderstrecke 10 angeordnet sind. Dabei sind das erste Objekt 71 und das zweite Objekt 72 in der Querrichtung 14 versetzt zueinander und teilweise nebeneinander angeordnet. Als Konturinformationen 142 werden unter anderem jeweils die Längen 24 der Objekte 71, 72, 73 entlang der Förderrichtung 12 und die Breiten 22 der Objekte 71, 72, 73 entlang der Querrichtung 14 bestimmt. Außerdem wird eine laterale Position der Objekte 71, 72, 73 in der Querrichtung 14 bestimmt. Dabei kann insbesondere bestimmt werden, dass das erste Objekt 71 und das zweite Objekt 72 in der Querrichtung 14 teilweise nebeneinander angeordnet sind.

### Bezugszeichenliste

- 1: Fördereinrichtung
- 10: Förderstrecke
- 12: Förderrichtung
- 14: Querrichtung
- 16: Förderband
- 20: Objekt
- 22: Objektbreite
- 24: Objektlänge
- 26: Objektabstand
- 28: Auflagewinkel
- 30: Transportrolle
- 32: Drehachse
- 34: Drehgeber
- 50: dielektrische Leitfähigkeit
- 51: erster Messgrößenverlauf
- 52: zweiter Messgrößenverlauf
- 53: dritter Messgrößenverlauf
- 54: vierter Messgrößenverlauf
- 55: fünfter Messgrößenverlauf
- 60: Zeitachse
- 71: erstes Objekt
- 72: zweites Objekt
- 73: drittes Objekt
- 100: Sensoreinrichtung
- 110: Hochfrequenzsensor
- 112: Trägerplatte
- 114: Einzelsensoren
- 116: Einspeisesignal
- 118: Auskoppelsignal
- 120: Sensorsignal
- 130: Detektionsbereich
- 140: Auswerteeinrichtung
- 142: Konturinformation
- 144: Vorverarbeitungsmodul
- 146: Konturerkennungsmodul

## Patentansprüche

1. Verfahren zum Erkennen aufeinanderfolgender Objekte (20) auf einer Förderstrecke (10) in einem auf der Förderstrecke (10) angeordneten Detektionsbereich (130) einer Sensoreinrichtung (100) mit einem an der Förderstrecke (10) angeordneten Hochfrequenzsensor (110) und einer mit dem Hochfrequenzsensor (110) verbundenen Auswerteeinrichtung (140), wobei das Verfahren die folgenden Schritte umfasst:
- Erzeugen eines in den Detektionsbereich (130) ausstrahlenden elektromagnetischen Hochfrequenzfeldes mittels des Hochfrequenzsensors (110),
- Messen eines zeitlichen Verlaufs einer dielektrischen Leitfähigkeit (50) in dem Detektionsbereich (130) mittels des Hochfrequenzfeldes,
- Bestimmen von Konturinformationen (142) der aufeinanderfolgenden Objekte (20) aus dem zeitlichen Verlauf der dielektrischen Leitfähigkeit (50) mittels der Auswerteeinrichtung (140),
**dadurch gekennzeichnet, dass**
der Hochfrequenzsensor (110) mehrere Einzelsensoren (114) umfasst, und dass die Einzelsensoren (114) nebeneinander entlang einer zu der Förderrichtung (12) der Förderstrecke (10) senkrecht ausgerichteten Querrichtung (14) der Förderstrecke (10) angeordnet sind.

2. Verfahren nach Anspruch 1, umfassend:
- Bestimmen eines Objektabstandes (26) zweier aufeinanderfolgender Objekte (20) als aus dem zeitlichen Verlauf der dielektrischen Leitfähigkeit (50) bestimmte Konturinformation (142)
und/oder
- Bestimmen eines Überlappens mehrerer aufeinanderfolgender Objekte (20) als aus dem zeitlichen Verlauf der dielektrischen Leitfähigkeit (50) bestimmte Konturinformation (142) und/oder
- Bestimmen von Auflagewinkeln (28) der den Detektionsbereich (130) durchquerenden Objekte (20) als aus dem zeitlichen Verlauf der dielektrischen Leitfähigkeit (50) bestimmte Konturinformation (142).

3. Verfahren nach einem der vorhergehenden Ansprüche,
wobei der Detektionsbereich (130) vollständig in einem Nahfeldbereich des Hochfrequenzfeldes des Hochfrequenzsensors (110) angeordnet ist, wobei vorzugsweise eine Entfernung des Detektionsbereichs (130) von dem Hochfrequenzsensor (110) weniger als eine Wellenlänge des Hochfrequenzfeldes, etwa weniger als ein Drittel der Wellenlänge des Hochfrequenzfeldes, beträgt.

4. Verfahren nach einem der vorhergehenden Ansprüche, wobei der Hochfrequenzsensor (110) als ein Hochfrequenzresonator ausgebildet ist und der zeitliche Verlauf der dielektrischen Leitfähigkeit (50) aus einer zeitlichen Änderung einer Resonanzfrequenz des Hochfrequenzresonators ermittelt wird
und/oder
der Hochfrequenzsensor als eine in den Detektionsbereich (130) ausstrahlende Antenne ausgebildet ist und der zeitliche Verlauf der dielektrischen Leitfähigkeit (50) aus einer zeitlichen Änderung der von der Antenne reflektierten elektrischen Leistung ermittelt wird.

5. Verfahren nach einem der vorhergehenden Ansprüche,
wobei die dielektrische Leitfähigkeit (50) aus einem reflektierten Anteil eines in den Hochfrequenzsensor (110) eingespeisten Hochfrequenzsignals (116) ermittelt wird.

6. Verfahren nach einem der vorhergehenden Ansprüche,
wobei der Hochfrequenzsensor (110) ein Mikrowellensensor und das Hochfrequenzfeld ein Mikrowellenfeld ist.

7. Verfahren nach einem der vorhergehenden Ansprüche,
wobei der Hochfrequenzsensor (110) in einer an der Förderstrecke (10) angeordneten Transportrolle (30) angeordnet ist, vorzugsweise auf einer Trägerplatte (112), die auf der Drehachse (32) der Transportrolle (30) angeordnet ist.

8. Verfahren nach einem der vorhergehenden Ansprüche, umfassend:
- Bestimmen von entlang der Querrichtung (14) orientierten Breiten (22) der Konturen der aufeinanderfolgenden Objekte (20) aus Einzelsignalen der Einzelsensoren (114).

9. Verfahren nach einem der vorhergehenden Ansprüche, umfassend:
- Anregen und Auslesen der Einzelsensoren (114), wobei die Einzelsensoren (114) zeitlich versetzt angeregt und ausgelesen werden.

10. Verfahren nach einem der vorhergehenden Ansprüche, umfassend:
- Bestimmen einer Fördergeschwindigkeit der Förderstrecke (10),
- Bestimmen von Längen (24) der Konturen der Objekte (20) aus der Fördergeschwindigkeit und dem zeitlichen Verlauf der dielektrischen Leitfähigkeit (50).

11. Verfahren nach Anspruch 10,
wobei die Fördergeschwindigkeit der Objekte (20) entlang der Förderstrecke (10) mittels eines Drehgebers (34) zur Bestimmung einer Rotationsgeschwindigkeit einer an der Förderstrecke (10) angeordneten Transportrolle (30) ermittelt wird.

12. Verfahren nach einem der vorhergehenden Ansprüche, umfassend:
- Ermitteln eines Abstands zwischen dem Objekt (20) und der Förderstrecke (10) mittels eines unter der Förderstrecke (10) angeordneten Distanzsensors, insbesondere mittels eines unter der Förderstrecke (10) angeordneten optischen Tasters.

13. Sensoreinrichtung (100) zum Erkennen aufeinanderfolgender Objekte (20) auf einer Förderstrecke (10),
wobei die Sensoreinrichtung (100) einen an der Förderstrecke (10) angeordneten Hochfrequenzsensor (110) und eine mit dem Hochfrequenzsensor (110) verbundene Auswerteeinrichtung (140) umfasst,
wobei die Sensoreinrichtung (100) einen auf der Förderstrecke (10) angeordneten Detektionsbereich (130) aufweist,
wobei der Hochfrequenzsensor (110) dazu ausgebildet ist, ein in den Detektionsbereich (130) ausstrahlendes elektromagnetisches Hochfrequenzfeld zu erzeugen,
wobei die Auswerteeinrichtung (140) dazu eingerichtet ist, einen zeitlichen Verlauf einer dielektrischen Leitfähigkeit (50) in dem Detektionsbereich (130) mittels des Hochfrequenzfeldes des Hochfrequenzsensors (110) zu messen,
wobei die Auswerteeinrichtung (140) dazu eingerichtet ist, Konturinformationen (142) der aufeinanderfolgenden Objekte (20) aus dem zeitlichen Verlauf der dielektrischen Leitfähigkeit (50) zu bestimmen,
**dadurch gekennzeichnet, dass**
der Hochfrequenzsensor (110) mehrere Einzelsensoren (114) umfasst, und dass die Einzelsensoren (114) nebeneinander entlang einer zu der Förderrichtung (12) der Förderstrecke (10) senkrecht ausgerichteten Querrichtung (14) der Förderstrecke (10) angeordnet sind.

14. Fördereinrichtung (1) mit einer Förderstrecke (10) und einer an der Förderstrecke (10) angeordneten Sensoreinrichtung (100) zum Erkennen aufeinanderfolgender Objekte (20) auf der Förderstrecke (10) gemäß Anspruch 13.

## Claims

1. A method of recognizing consecutive objects (20) on a conveying path (10) in a detection zone (130), arranged on the conveying path (10), of a sensor device (100) comprising a radio frequency sensor (110) arranged at the conveying path (10); and an evaluation device (140) connected to the radio frequency sensor (110),
wherein the method comprises the following steps:
- generating an electromagnetic radio frequency field radiating into the detection zone (130) by means of the radio frequency sensor (110);
- measuring a time curve of a dielectric conductivity (50) in the detection zone (130) by means of the radio frequency field; and
- determining contour information (142) of the consecutive objects (20) from the time curve of the dielectric conductivity (50) by means of the evaluation device (140),
**characterized in that**
the radio frequency sensor (110) comprises a plurality of individual sensors (114); and
**in that** the individual sensors (114) are arranged next to one another along a transverse direction (14) of the conveying path (10) which is oriented perpendicular to the conveying direction (12) of the conveying path (10).

2. A method in accordance with claim 1, comprising:
- a determination of an object distance (26) of two consecutive objects (20) as contour information (142) determined from the time curve of the dielectric conductivity (50);
- a determination of an overlap of a plurality of consecutive objects (20) as contour information (142) determined from the time curve of the dielectric conductivity (50);
and/or
- a determination of support angles (28) of the objects (20) passing through the detection zone (130) as contour information (142) determined from the time curve of the dielectric conductivity (50).

3. A method in accordance with one of the preceding claims,
wherein the detection zone (130) is completely arranged in a near field zone of the radio frequency field of the radio frequency sensor (110),
with a distance of the detection zone (130) from the radio frequency sensor (110) preferably amounting to less than one wavelength of the radio frequency field, approximately to less than one third of the wavelength of the radio frequency field.

4. A method in accordance with any one of the preceding claims,
wherein the radio frequency sensor (110) is configured as a radio frequency resonator and the time curve of the dielectric conductivity (50) is determined from a time change of a resonant frequency of the radio frequency resonator;
and/or
the radio frequency sensor is configured as an antenna radiating into the detection zone (130) and the time curve of the dielectric conductivity (50) is determined from a time change of the electrical power reflected by the antenna.

5. A method in accordance with any one of the preceding claims,
wherein the dielectric conductivity (50) is determined from a reflected portion of a radio frequency signal (116) fed into the radio frequency sensor (110).

6. A method in accordance with any one of the preceding claims,
wherein the radio frequency sensor (110) is a microwave sensor and the radio frequency field is a microwave field.

7. A method in accordance with any one of the preceding claims,
wherein the radio frequency sensor (110) is arranged in a transport roller (30) arranged at the conveying path (10), preferably on a support plate (112) which is arranged on the rotary axle (32) of the transport roller (30).

8. A method in accordance with any one of the preceding claims, comprising:
- a determination of widths (22), oriented along the transverse direction (14), of the contours of the consecutive objects (20) from individual signals of the individual sensors (114).

9. A method in accordance with any one of the preceding claims, comprising:
- an exciting and a reading out of the individual sensors (114), with the individual sensors (114) being excited and read out offset in time.

10. A method in accordance with any one of the preceding claims, comprising:
- a determination of a conveying speed of the conveying path (10); and
- a determination of lengths (24) of the contours of the objects (20) from the conveying speed and from the time curve of the dielectric conductivity (50).

11. A method in accordance with claim 10,
wherein the conveying speed of the objects (20) along the conveying path (10) is determined by means of a rotary encoder (34) for determining a rotational speed of a transport roller (30) arranged at the conveying path (10).

12. A method in accordance with any one of the preceding claims, comprising:
- a determination of a distance between the object (20) and the conveying path (10) by means of a distance sensor arranged below the conveying path (10), in particular by means of an optical sensor arranged below the conveying path (10).

13. A sensor device (100) for recognizing consecutive objects (20) on a conveying path (10),
wherein the sensor device (100) comprises a radio frequency sensor (110) arranged at the conveying path (10); and an evaluation device (140) connected to the radio frequency sensor (110);
wherein the sensor device (100) has a detection zone (130) arranged on the conveying path (10);
wherein the radio frequency sensor (110) is configured to generate an electromagnetic radio frequency field radiating into the detection zone (130);
wherein the evaluation device (140) is configured to measure a time curve of a dielectric conductivity (50) in the detection zone (130) by means of the radio frequency field of the radio frequency sensor (110); and
wherein the evaluation device (140) is configured to determine contour information (142) of the consecutive objects (20) from the time curve of the dielectric conductivity (50),
**characterized in that**
the radio frequency sensor (110) comprises a plurality of individual sensors (114); and
**in that** the individual sensors (114) are arranged next to one another along a transverse direction (14) of the conveying path (10) which is oriented perpendicular to a conveying direction (12) of the conveying path (10).

14. A conveying device (1) having a conveying path (10) and having a sensor device (100) arranged at the conveying path (10) for recognizing consecutive objects (20) on the conveying path (10) in accordance with claim 13.

## Revendications

1. Procédé d'identification d'objets successifs (20) sur une voie de transport (10) dans une zone de détection (130), disposée sur la voie de transport (10), d'un dispositif capteur (100) comprenant un capteur haute fréquence (110) disposé sur la voie de transport (10) et un dispositif d'évaluation (140) connecté au capteur haute fréquence (110),
le procédé comprenant les étapes suivantes consistant à :
- générer un champ électromagnétique haute fréquence, rayonnant dans la zone de détection (130), au moyen du capteur haute fréquence (110),
- mesurer une évolution temporelle d'une conductivité diélectrique (50) dans la zone de détection (130) au moyen du champ haute fréquence,
- déterminer des informations de contour (142) des objets successifs (20) à partir de l'évolution temporelle de la conductivité diélectrique (50) au moyen du dispositif d'évaluation (140),
**caractérisé en ce que**
le capteur haute fréquence (110) comprend plusieurs capteurs individuels (114), et **en ce que**
les capteurs individuels (114) sont disposés les uns à côté des autres selon une direction transversale (14) de la voie de transport (10) orientée perpendiculairement à la direction de transport (12) de la voie de transport (10).

2. Procédé selon la revendication 1, consistant à :
- déterminer une distance d'objet (26) de deux objets successifs (20) en tant qu'information de contour (142) déterminée à partir de l'évolution temporelle de la conductivité diélectrique (50),
et/ou
- déterminer un chevauchement de plusieurs objets successifs (20) en tant qu'information de contour (142) déterminée à partir de l'évolution temporelle de la conductivité diélectrique (50),
et/ou
- déterminer des angles d'appui (28) des objets (20) traversant la zone de détection (130) en tant qu'information de contour (142) déterminée à partir de l'évolution temporelle de la conductivité diélectrique (50).

3. Procédé selon l'une des revendications précédentes,
dans lequel la zone de détection (130) est entièrement disposée dans une zone de champ proche du champ haute fréquence du capteur haute fréquence (110),
de préférence, une distance de la zone de détection (130) par rapport au capteur haute fréquence (110) est inférieure à une longueur d'onde du champ haute fréquence, par exemple inférieure à un tiers de la longueur d'onde du champ haute fréquence.

4. Procédé selon l'une des revendications précédentes,
dans lequel le capteur haute fréquence (110) est réalisé sous forme de résonateur haute fréquence, et l'évolution temporelle de la conductivité diélectrique (50) est déterminée à partir d'une variation temporelle d'une fréquence de résonance du résonateur haute fréquence,
et/ou
le capteur haute fréquence est réalisé sous forme d'antenne rayonnant dans la zone de détection (130), et l'évolution temporelle de la conductivité diélectrique (50) est déterminée à partir d'une variation temporelle de la puissance électrique réfléchie par l'antenne.

5. Procédé selon l'une des revendications précédentes,
dans lequel la conductivité diélectrique (50) est déterminée à partir d'une partie réfléchie d'un signal haute fréquence (116) injecté dans le capteur haute fréquence (110).

6. Procédé selon l'une des revendications précédentes,
dans lequel le capteur haute fréquence (110) est un capteur hyperfréquence et le champ haute fréquence est un champ hyperfréquence.

7. Procédé selon l'une des revendications précédentes,
dans lequel le capteur haute fréquence (110) est disposé dans un rouleau de transport (30) disposé sur la voie de transport (10), de préférence sur une plaque porteuse (112) disposée sur l'axe de rotation (32) du rouleau de transport (30).

8. Procédé selon l'une des revendications précédentes, consistant à :
- déterminer des largeurs (22) des contours des objets successifs (20), orientées selon la direction transversale (14), à partir de signaux individuels des capteurs individuels (114).

9. Procédé selon l'une des revendications précédentes, consistant à :
- exciter et lire les capteurs individuels (114), les capteurs individuels (114) étant excités et lus de manière décalée dans le temps.

10. Procédé selon l'une des revendications précédentes, consistant à :
- déterminer une vitesse de transport de la voie de transport (10),
- déterminer des longueurs (24) des contours des objets (20) à partir de la vitesse de transport et de l'évolution temporelle de la conductivité diélectrique (50).

11. Procédé selon la revendication 10,
dans lequel la vitesse de transport des objets (20) le long de la voie de transport (10) est déterminée au moyen d'un capteur de rotation (34) destiné à déterminer une vitesse de rotation d'un rouleau de transport (30) disposé sur la voie de transport (10).

12. Procédé selon l'une des revendications précédentes, consistant à :
- déterminer une distance entre l'objet (20) et la voie de transport (10) au moyen d'un capteur de distance disposé sous la voie de transport (10), en particulier au moyen d'un palpeur optique disposé sous la voie de transport (10).

13. Dispositif capteur (100) pour l'identification d'objets successifs (20) sur une voie de transport (10),
dans lequel
le dispositif capteur (100) comprend un capteur haute fréquence (110) disposé sur la voie de transport (10) et un dispositif d'évaluation (140) connecté au capteur haute fréquence (110),
le dispositif capteur (100) présente une zone de détection (130) disposée sur la voie de transport (10),
le capteur haute fréquence (110) est réalisé pour générer un champ électromagnétique haute fréquence rayonnant dans la zone de détection (130), le dispositif d'évaluation (140) est conçu pour mesurer une évolution temporelle d'une conductivité diélectrique (50) dans la zone de détection (130) au moyen du champ haute fréquence du capteur haute fréquence (110),
le dispositif d'évaluation (140) est conçu pour déterminer des informations de contour (142) des objets successifs (20) à partir de l'évolution temporelle de la conductivité diélectrique (50),
**caractérisé en ce que**
le capteur haute fréquence (110) comprend plusieurs capteurs individuels (114), et **en ce que**
les capteurs individuels (114) sont disposés les uns à côté des autres selon une direction transversale (14) de la voie de transport (10) orientée perpendiculairement à la direction de transport (12) de la voie de transport (10).

14. Dispositif de transport (1) comprenant une voie de transport (10) et un dispositif capteur (100), disposé sur la voie de transport (10) pour identifier des objets successifs (20) sur la voie de transport (10), selon la revendication 13.
